(19) **Europäisches Patentamt**

**European Patent Office**

**Office européen des brevets**

(11) **EP 1 225 452 A2**

(12) **EUROPÄISCHE PATENTANMELDUNG**

(43) Veröffentlichungstag:
24.07.2002 Patentblatt 2002/30

(51) Int Cl.⁷: **G01R 19/00**

(21) Anmeldenummer: 01126822.4

(22) Anmeldetag: 10.11.2001

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **19.01.2001 DE 10102344**

(71) Anmelder: **ROBERT BOSCH GMBH**
**70442 Stuttgart (DE)**

(72) Erfinder:
• **Gronbach, Roman**
**70825 Korntal (DE)**
• **Rieger, Reinhard**
**70372 Stuttgart (DE)**

(54) **Verfahren zur Messung des Stromes in Halbbrücken**

(57) Die Erfindung bezieht sich auf ein Verfahren zur Erfassung von Leiterströmen (3, 4) in versetzt getakteten Halbbrücken (12, 13) an einer Drehfeldmaschine (10), die an einem mehrsträngigen Umrichter (14) betrieben wird. Diese umfaßt mindestens einen ersten Umrichterstrang (15) und einen zweiten Umrichterstrang (16). Die Erfassungszeitpunkte (38, 39) der Leiterströme (3, 4) liegen derart, daß in Pulspausen (30, 31) eines der Leiterströme (3, 4) die Erfassung des jeweils anderen Leiterstromes (3, 4) erfolgt.

Fig.5

## Beschreibung

### Technisches Gebiet

Zur Erzeugung von in Kraftfahrzeugen benötigter elektrischer Energie werden heute Klauenpolgeneratoren eingesetzt. Bei Klauenpolgeneratoren handelt es sich um Drehstromgeneratoren, deren Ausgangsstrom mit Hilfe einer Diodenbrücke gleichgerichtet wird. Der gleichgerichtete Strom wird dann zur Versorgung der elektrischen Verbraucher des Fahrzeuges sowie zur Ladung der Batterie eingesetzt. Elektrische Drehfeldmaschinen werden in der Regel an mehrsträngigen Umrichtern betrieben. Werden umgewickelte Drehfeldmaschinen, zum Beispiel ein Klauenpolgenerator mit zwei Ständerwicklungen pro Strang, versetzt geschaltet, so kann der Leiterstrom mit einem oder zwei Strommeßwandlern oder zwei Shunts gemessen werden.

### Stand der Technik

Aus DE 198 04 096 A1 ist eine Vorrichtung und ein Verfahren zur Regelung eines Generators bekannt geworden. Darin wird eine Vorrichtung und ein Verfahren zur Regelung eines Klauenpolgenerators beschrieben, mit dem die sich an den Generator anschließende Gleichrichterbrücke kurzzeitig kurzgeschlossen werden kann, wodurch in den Ständer Induktivitätenenergie zwischengespeichert wird, die zu höheren Strangspannungen führt. Durch geeignete Wahl der Ansteuerfrequenz für einen Transistor, der das Kurzschließen der Diodenbrücke ermöglicht, läßt sich eine Ausgangsspannung des Generators auf gewünschtem Spannungsniveau einstellen, die gegenüber der herkömmlichen Bordnetzspannung deutlich höher liegt. In weiteren Ausgestaltungen der Lösung gemäß DE 198 04 096 A1 wird die Diodenbrücke selbst durch steuerbare Schaltelemente (z.B. Transistoren) ersetzt und durch geeignete Ansteuerung lassen sich Spannungsanpassungen realisieren.

Der Zeitschrift "Auto & Elektronik 2/2000, Seiten 85 bis 87" ist ein Aufsatz betreffend Meßwandler für das Automobil (Verfasser Klaus Oertel) zu entnehmen. Dort werden Strommessungen für Antriebsteile von Elektrofahrzeugen, seien es Elektro- oder Hybridfahrzeuge, beschrieben. In diesen wird oft als Antrieb ein Asynchronmotor eingesetzt. Zur Regelung des Asynchronmotors wird eine Strommessung durchgeführt. Beim Einsatz von fremderregten Synchronmotoren erfolgt zusätzlich eine Messung des Erregerstromes des Rotors des Synchronmotors. Damit eine exakte Regelung des Antriebsmotors erfolgen kann, wird der Strom der Motorphasen gemessen und der Meßwert an die Steuerelektronik geleitet. Aus Kostengründen werden lediglich zwei Phasen erfaßt und die dritte Phase des Elektromotors elektronisch ermittelt. Die zu messenden Ströme liegen üblicherweise zwischen 200 A und 400 A. Da im Fahrzeug eine unipolare Batteriespannung vorhanden ist, sollten die Stromwandler Wechselströme, Gleichströme und komplexe Ströme mit einer unipolaren Versorgungsspannung abbilden. Die Stromwandler müssen in einem weiten Temperaturbereich, vorzugsweise zwischen - 40°C bis 105°C funktionieren und den Anforderungen hinsichtlich Erschütterung und Stoßbeanspruchungen im Kraftfahrzeug standhalten. Zur Erfassung des Leiterstromes bei versetzt geschalteten, umgewickelten Maschinen kann der Strommeßwandler einer jeden der Ständerwicklung zugeordnet sein, so daß der Strommeßwandler die im Leiter fließenden Ströme unmittelbar mißt. Daneben ist es möglich, die Strommessung in demjenigen Strang eines mehrsträngigen Urnrichters zu messen, der mit der betreffenden Ständerwicklung der Drehfeldmaschine verbunden ist. Dies erfolgt vorzugsweise im Niederspannungsteil des mehrsträngigen Umrichters. Die Strommessung kann hingegen auch in dem Teil des mehrsträngigen Umrichters erfolgen, in welchem die höheren Spannungen auftreten. Daneben besteht eine andere Messung der Stromerfassung in Leitern der Ständerwicklung einer umgewickelten elektrischen Maschine darin, den Leiterstrom in den Ständerwicklungen gemeinsam zu messen.

Als Stromsensoren können Shunts, Kompensationswandler oder dergleichen eingesetzt werden.

Den aufgezeigten Verfahren und Strommeßanordnungen ist gemeinsam, daß stets - sei es im mehrsträngigen Umrichter oder den beiden Ständerwicklungen pro Strang einer elektrischen Drehfeldmaschine - der Leiterstrom mit zwei Strommeßwandlern ermittelt werden muß. Dies bedeutet einen höheren Aufwand an Bauteilen und Auswerteelektronik; eine gemeinsame Messung der Leiterströme in den beiden Leitersträngen einer elektrischen Drehfeldmaschine, wie zum Beispiel eines Klauenpolgenerators zum Einsatz in Kraftfahrzeugen, birgt Ungenauigkeiten.

### Vorteile der Erfindung

Mit dem erfindungsgemäß vorgeschlagenen Verfahren kann aus lediglich einem Strommeßsignal auf zwei Leiterströme geschlossen werden. Es halbiert sich die Menge der einzusetzenden Strommeßwandler, ebenso wie die vorzuhaltende Auswerteelektronik. Mit dem vorgeschlagenen Verfahren werden stets die Mittelwerte der zu messenden Ströme erfaßt, so daß deren Berechnung in der Auswerteelektronik unterbleiben kann. In Pulspausen der zu messenden Leiterströme liegt jeweils ein Leiterstromwert vor, während der andere 0 beträgt, so daß eine Erfassung der Leiterströme $I_1$, $I_2$ abwechselnd erfolgen kann.

Die Abtastfrequenz, mit der die Leiter der Ständerwicklungspakete des Ständers einer versetzt getakteten elektrischen Drehfeldmaschine abgetastet werden können ergibt sich zu

$$f = 2 \cdot f_{pwm}/n \text{ mit } n = \in \{1, 3, 5, 7, 9.....\}$$

Die zu beliebigen Zeitpunkten ausgelöste Messung der Leiterströme kann zu allen Zeitpunkten t = n · T/2 erfolgen, vorzugsweise wird die Strommessung dabei stets dann erfolgen, wenn in einem Leiter, dessen Leiterstrom zu erfassen ist, gerade eine Pulspause vorliegt, so daß die Stromerfassung in vorteilhafter Weise in die Pulsweitenmodulation integriert werden kann.

In vorteilhafter Ausgestaltung des erfindungsgemäß vorgeschlagenen Verfahrens wird das Auslösesignal für die Messung der Leiterströme von demjenigen Controller erzeugt, der auch die Pulsweitenmodulation mittels der in mehrsträngigen Umrichtern strangweise vorgesehenen Transistoren steuert. Damit läßt sich der Erfassungszeitpunkt eines der Leiterströme genau in die Pulspause des anderen zu erfassenden Leiterstromes legen. So ist eine synchron erfolgende Abfolge von Transistorenansteuerung und exakter Strommessung in den Pulspausen der Leiterströme realisierbar.

Für die in den Pulspausen mit der eingestellten Abtastfrequenz abzutastenden Leiterströme sind minimale Meßzeiten erforderlich, die am Mikrocontroller, der die Pulspausen in den Leiterströmen generiert, nicht unterschritten werden. Der Bereich, in dem eine Pulsweitenmodulation erfolgen kann, ist durch die Mindestein- und Mindestausschaltzeit für die Strommeßanordnungen vorgegeben.

Zeichnung

Anhand der Zeichnung wird die Erfindung nachstehend näher erläutert.

Es zeigt:

Figur 1.1 die Stromverläufe zweier Leiterströme bei einer ersten Einschaltdauer,

Figur 1.2 die Stromverläufe zweier Leiterströme über eine Einschaltdauer, die oberhalb der halben Taktzeit liegt,

Figur 2 eine erfindungsgemäß beschaltete Auswerteanordnung,

Figur 3 die fließenden Ströme in den Leitern von Ständerwicklung einer elektrischen Drehfeldmaschine,

Figur 4 die Signalverläufe im PWM-Bereich durch Überlagerung der Leiterströme,

Figur 5 die Zeitpunkte der Strommessung im Diagramm der Stromverläufe,

Figur 6 die Zeitpunkte der Strommessung bei Überlagerung des gesamten PWM-Bereiches und

Figur 7 die Abtastzeitpunkte der Strommessung im Diagramm der Stromverläufe für eine kleinere Abtasthäufigkeit.

Ausführungsvarianten

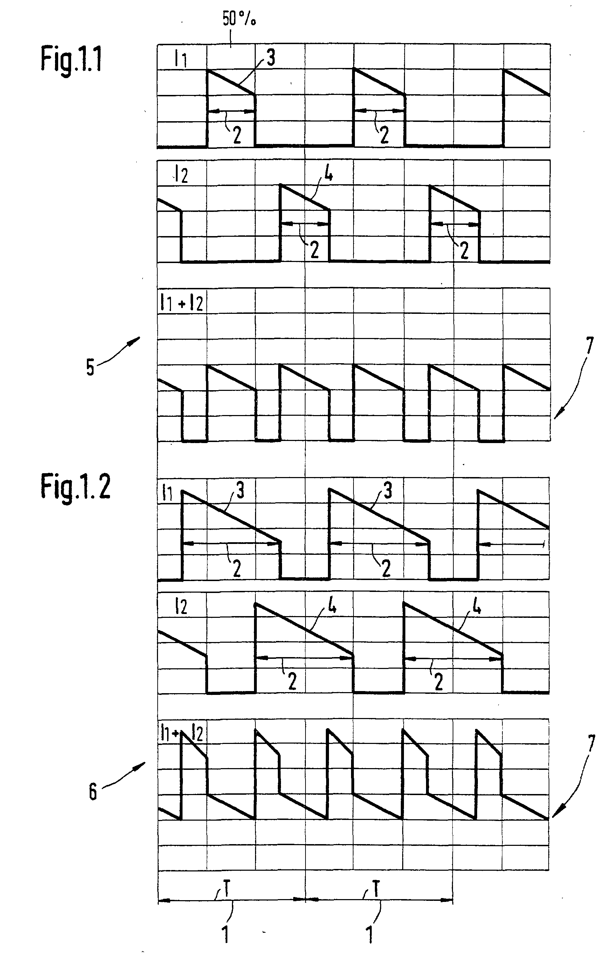

Aus Figur 1.1 und 1.2 sind die Verläufe zweier Ströme $I_1$, $I_2$ bei unterschiedlicher Einschaltdauer in bezug auf die Taktzeit entnehmbar.

In beiden Diagrammen gemäß der Figuren 1.1 bzw. 1.2 ist die Taktzeit mit T bzw. Bezugszeichen 1 identifiziert. In der Darstellung gemäß Figur 1.1 beträgt eine Einschaltdauer 2 eines Stromes 3 im ersten Leiter ($I_1$) ca. 1/3 der Taktweite T bzw. Bezugszeichen 1. Ein Strom 4 im zweiten Leiter ($I_2$) ist in bezug auf den Strom 3 im ersten Leiter versetzt getaktet, so daß der Strom 4 im zweiten Leiter dann anliegt, wenn eine Pulspause im darüberliegend aufgetragenen Strom 3 im ersten Leiter auftritt. Eine Überlagerung der im ersten Verhältnis 5 von $T_{ein}/T$ getakteten Ströme 3 und 4 zeigt, daß sich ein sägezahnförmiges Profil herausbildet, wobei aus der Summation 7 der Ströme hervorgeht, daß zwischen dem Strom im ersten Leiter 3 und dem Strom 4 im zweiten Leiter 3 jeweils Pulspausen auftreten. Die Länge dieser Pulspausen ist abhängig von den gewählten Einschaltdauern 2, zu denen Ströme 3, 4 in den Leitern beispielsweise von umgewickelten Drehfeldmaschinen, so zum Beispiel Klauenpolgeneratoren mit einem Wicklungspaket, eine erste Ständerwicklung und eine zweite Ständerwicklung enthaltend, auftreten.

Aus der Darstellung gemäß Figur 1.2 geht eine versetzte Taktung mit einem zweiten Verhältnis 6 $T_{ein}/T$ näher hervor. Bei diesem Einschaltverhältnis liegt die Einschaltdauer 2 des Stromes 3 im ersten Leiter ($I_1$) > 50% der Taktzeit T (Bezugszeichen 1). Versetzt dazu verläuft der Strom 4 im zweiten Leiter ($I_2$), der ebenfalls während einer Einschaltdauer 2 ($T_{ein}$) anliegt und die Pulspause im Strom 3 im ersten Leiter ($I_1$) überlappend abdeckt.

Aus der Summation 7 des Stromes 3 im ersten Leiter ($I_1$) und des Stromes 4 im zweiten Leiter ($I_2$) im weiten Verhältnis 6 $T_{ein}/T$ geht hervor, daß auch aus der Summation des Stromes 3 und des Stromes 4 im zweiten Verhältnis von Einschaltdauer 2 zur Taktweite 1, bezeichnet durch Bezugszeichen 6, ein sägezahnförmiges Stromprofil hervorgeht.

Beiden Leiterströmen 3 bzw. 4 ist gemeinsam, daß sich abhängig von der gewählten Pulsweitenmodulation an einem mehrsträngigen Umrichter 14 beispielsweise unterschiedlich lange Pulspausen einstellen, die zur Erfassung von Leiterströmen in den Leitern herangezogen werden können.

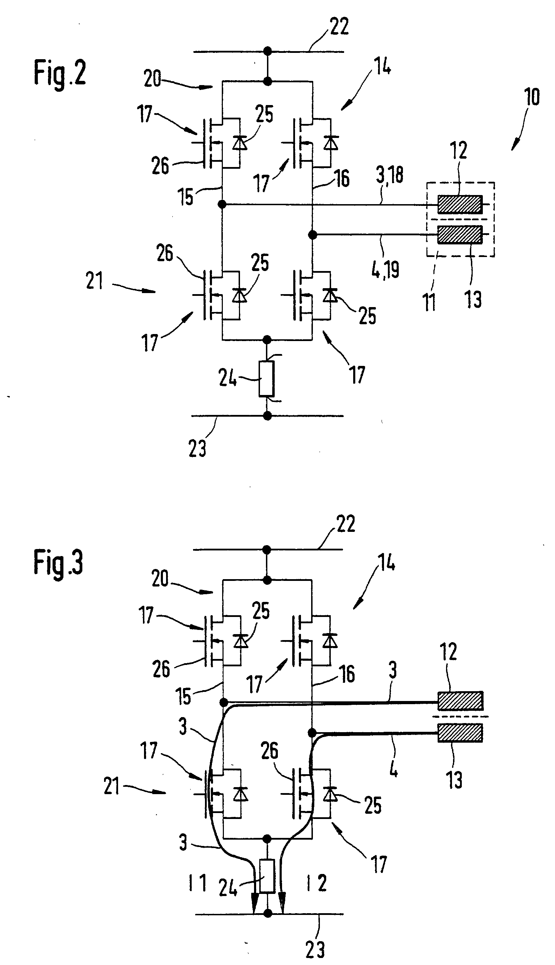

Aus der Darstellung gemäß Figur 2 geht eine erfindungsgemäß konfigurierte Strommeßanordnung näher hervor.

Ein Wicklungspaket 11 einer hier nicht näher dargestellten elektrischen Drehfeldmaschine 10, wie eines Klauenpolgenerators enthält eine erste Ständerwicklung 12 sowie eine zweite Ständerwicklung 13. Diese Konfiguration ist beispielsweise bei Klauenpolgeneratoren mit zwei Ständerwicklungen pro Strang gebräuchlich, die umgewickelte Maschinen darstellen, die versetzt geschaltet werden. Solche elektrischen Drehfeldmaschinen 10 werden in der Regel an mehrsträngigen Umrichtern 14 betrieben. Die erste Ständerwicklung 12 ist über einen Leiter mit einem ersten Umrichterstrang 15 des mehrsträngigen Umrichters 14 verbunden, während die zweite Ständerwicklung 13 über einen Leiter mit dem zweiten Umrichterstrang 16 des mehrsträngigen Umrichters 14 elektrisch in Verbindung steht.

Der mehrsträngige Umrichter 14 ist zwischen einem Leiter 22 und einer Masseverbindung 23 geschaltet und umfaßt in der Ausführungsvariante gemäß Figur 2 zwei parallelgeschaltete Umrichterstränge 15 bzw. 16. Jeder der Umrichterstränge 15 bzw. 16, der mit einem Leiter der entsprechenden Ständerwicklung 12 bzw. 13 des Wicklungspaketes 11 verbunden ist, umfaßt zwei Transistoren 17, denen jeweils eine Sperrdiode 25 parallelgeschaltet ist. Mit Bezugszeichen 26 ist die jeweilige Transistorbasis bezeichnet. In Bezug auf die elektrischen Anschlußpunkte der Leiterstränge 18, 19 der Ständerwicklungen 12, 13 ist mit Bezugszeichen 20 der Spannungsbereich des mehrsträngigen Umrichters 14 identifiziert, in welchem ein höheres Spannungsniveau vorliegt, während mit Bezugszeichen 21 die Niederspannungsseite 21 des mehrsträngigen Umrichters 14 bezeichnet ist.

Im dargestellten Ausführungsbeispiel gemäß Figur 2 befindet sich ein Stromsensor 24 zwischen der Masseverbindung 23 und der Niederspannungsseite 21 des mehrsträngigen Umrichters 14. Der Strommeßsensor 24 könnte ebenso gut zwischen dem Leiter 22 und dem Bereich der höheren Spannung 20 am mehrsträngigen Umrichter 14 vorgesehen sein. Mit dem erfindungsgemäß vorgeschlagenen Verfahren lassen sich der Strom 3 im ersten Leiter 18 der Ständerwicklung 12 und der Strom 4 im Leiter 19 der zweiten Ständerwicklung 13 erfassen.

Aus der Darstellung gemäß Figur 3 gehen die fließenden Ströme $I_1$, $I_2$ in den Leitern der Ständerwicklungen der elektrischen Drehfeldmaschine näher hervor.

Im Leiter 18 der ersten Ständerwicklung 12 fließt der Strom 3 über den Transistor 17 im ersten Umrichterstrang 15. Der Strom 3 wird von einem als Shunt 24 ausgebildeten Stromsensor in der Niederspannungsseite 21 des mehrsträngigen Umrichters 14 gemessen. Im Leite 19 der zweiten Ständerwicklung 13 fließt der Leiterstrom 4, der über den Transistor 17 im zweiten Umrichterstrang 16 auf der Niederspannungsseite 21 ebenfalls über den Stromsensor 24 fließt. Beide Transistoren 17 im ersten Umrichterstrang 15 bzw. im zweiten Umrichterstrang 16 sind mit einer Sperrdiode 25 versehen, die ein Fließen der Leiterströme 3 bzw. 4 über die jeweiligen Transistoren 17 auf der Niederspannungsseite 21 des mehrsträngigen Umrichters 14 erzwingen.

Im Zusammenhang mit Figur 3 sei auf die Verläufe der Leiterströme 3 bzw. 4 gemäß der Figuren 1.1 und 1.2 verwiesen. Über den in der Darstellung gemäß Figur 3 mit Bezugzeichen 24 bezeichneten Stromsensor, welcher als ein Shunt oder als ein Kompensationswandler beschaffen sein kann, fließen beide Leiterströme 3 bzw. 4 ($I_1$,$I_2$). Da die Ströme 3 bzw. 4 in den Leitern 18 bzw. 19 der Ständerwicklungen 12. bzw. 13 der elektrischen Drehfeldmaschine 10 versetzt zueinander getaktet sind, können beide Leiterströme 3 bzw. 4 über einen Stromsensor 24 geführt werden. Aufgrund der jeweiligen Einschaltverhältnisse $T_{ein}/T$ 5 bzw. 6 gemäß den Diagrammen in Figur 1.1 bzw. 1.2 stellen sich unterschiedlich lange Pulspausen jeweils abwechselnd in den Strömen 3 bzw. 4 in den Leitern 18, 19 der versetzt getakteten Ständerwicklungen 12 bzw. 13 ein.

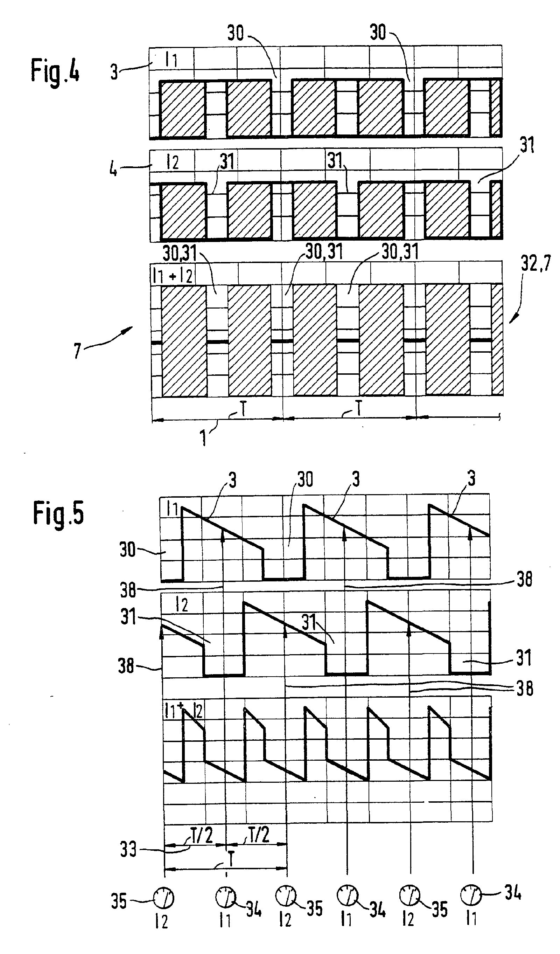

Aus der Darstellung gemäß Figur 4 gehen die bei Überlagerung des gesamten Pulsweitenmodulations-Bereiches resultierenden Stromverläufe hervor. Während einer Taktzeit T (Bezugszeichen 1) ist der Strom 3 $I_1$ im ersten Leiter 18 der Ständerwicklung 12 durch zwei miteinander verbundene schraffierte Rechtecke symbolisiert. An diesen schließt sich eine Pulspause 30 des Stromes 3 im Leiter 18 an, die abhängig von der eingestellten Einschaltdauer 2 $T_{ein}$ ist.

Analoges gilt für die Darstellung des Stromes 4 im Leiter 19 der zweiten Ständerwicklung 13. Zwischen den den Strom 4 im Leiter 19 der Ständerwicklung 13 repräsentierenden schraffierten Rechtecken befinden sich Pulspausen 31, in welchen der Strom 4 im Leiter 19 seinen Nullwert annimmt.

Aus der überlagerten, mit Bezugszeichen 32 bezeichneten Darstellung geht die Summation des Stromes 3 bzw. des Stromes 4 in den Leitern 18 bzw. 19 des Wicklungspaktes 11 der elektrischen Drehfeldmaschine 10 hervor. Während der Taktzeit 1 stellen sich zwischen den resultierenden Stromwerten der Leiterströme 3 bzw.4 Pulspausen 30 bzw. 21 ein, die jeweils einem der beiden zu erfassenden Leiterströme 3 bzw. 4 zugeordnet werden können.

Aus der Darstellung gemäß Figur 5 gehen die Zeitpunkte der Strommessung näher hervor.

Die Diagramme der Leiterströme 3 bzw. 4 gemäß Figur 5 entsprechen denen der Darstellung gemäß Figur 1.2, in welchen der Strom 3 bzw. der Strom 4 eine Einschaltdauer 2 von > 50% der Taktzeit T (Bezugszeichen 1) erfährt.

Die Verläufe der Ströme 3 bzw. 4 in den Leitern 18 bzw. 19 des Wicklungspaketes 11 der elektrischen Drehfeldmaschine 10 verlaufen sägezahnförmig. Die überlagerte Darstellung 32 der Ströme 3 bzw. 4 in den Leitern 18 bzw. 19 des Wicklungspaketes 11 hat ebenfalls ein sägezahnförmiges Aussehen. Mit den symbolisierten Ampèremetern 34 bzw. 35, von denen jeweils eines dem Strom 3 im Leiter 18 bzw. dem Strom 4 im Leiter 19 zugeordnet ist, soll gemäß der Darstellung in Figur 5 die Einschaltung der Stromerfassung gekennzeichnet werden. Zu Beginn der halben Taktzeit 33 T/2 wird der Strom 4 im Leiter 19 zum Zeitpunkt 38 gemessen. Eine halbe Taktzeit später erfolgt eine Messung des Stromes 3 im ersten Leiter 18 des Wicklungspaketes 11, symbolisiert durch den sich vom Amperemeter 34 erstreckenden Pfeil. Eine weitere halbe Taktzeit 33 später erfolgt wiederum eine Messung des Stromes 4 im Leiter 19 des Wicklungspaketes 11 der elektrischen Drehfeldmaschine 10. Die erstgenannte Messung erfolgt in einer Pulspause 30 des Stromes 3 im Leiter 18, während die zweite Strommessung während einer Pulspause 31 des zweiten Stromes 4 im Leiter 19 des Wicklungspaketes 11 erfolgt. Mittels des Stromsensors 24 wird der jeweils fließende Strom im Leiter 18 bzw. 19 genau dann gemessen, wenn einer der Ströme 3 bzw. 4 in den Leitern 18 oder 19 während einer sich einstellenden Pulspause 30, 31, einstellbar über die Pulsweitenmodulation, gerade nicht fließt. Die Frequenz der Strommessung ergibt sich dabei aus allen Möglichkeiten der Strom-Istwertabtastung. So beträgt die Abtastfrequenz:

$$f = 2 \cdot f_{pwm}/n \text{ mit } n \in \{1, 3, 5, 7, 9....\}.$$

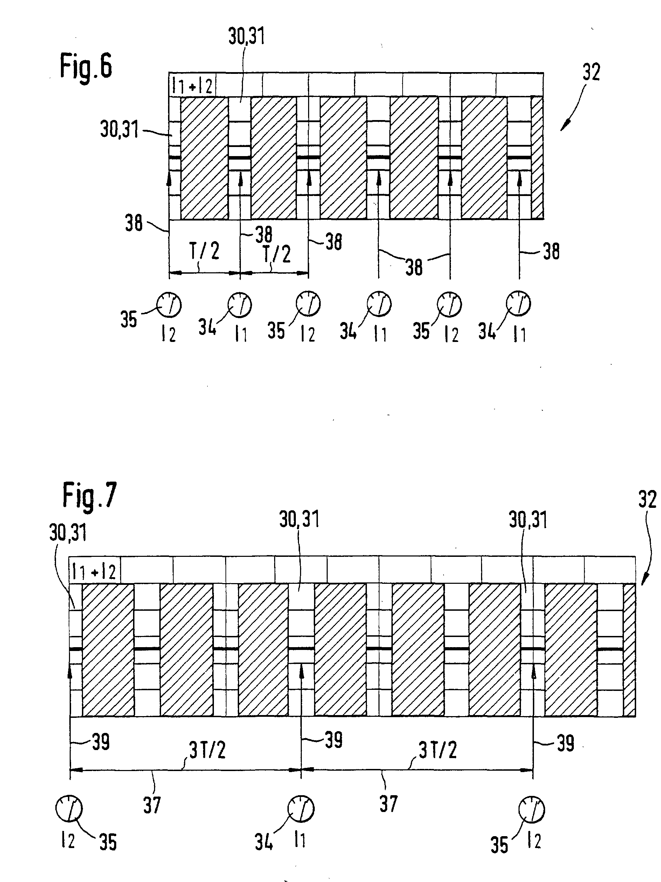

Aus der Darstellung gemäß Figur 5 geht hervor, daß eine abwechselnde Erfassung der Leiterströme 3 bzw. 4 erfolgt. Die Erfassung der Ströme erfolgt abhängig von der Länge der Pulspausen 30, 31, wobei die minimal erforderlichen Ein- bzw. Ausschaltzeiten für die Strommessung eingehalten werden müssen. Darin findet der Stellbereich für das Pulsweitenmodulations-Signal seine untere Begrenzung. Aus der Darstellung gemäß Figur 6 gehen die Zeitpunkte der Strommessung bei Überlagerung des gesamten Pulsweitenmodulations-Bereiches näher hervor. Gemäß dieser Figur ist eine jede sich einstellende Pulspause 30 bzw. 31 für die jeweils aktuellen Ströme 3 bzw. 4 in den Leitern 18, 19 ein geeigneter Meßzeitpunkt 38 nach Verstreichen einer halben Taktzeit 33, hier T/2. Innerhalb einer jeden sich einstellenden Pulspause 30 bzw. 31 für den Strom 3 im Leiter 18 bzw. den Strom 4 im Leiter 19 erfolgt eine Strommessung.

Aus der Darstellung gemäß Figur 7 geht hervor, daß bei einer geringeren Abtastfrequenz, beispielsweise 3T/2 gemäß Figur 7 die Meßzeitpunkte 39 1,5 Taktenzeiten 1 überschreiten. Analog zur Darstellung gemäß Figur 6 erfolgt während der Pulspausen 30 bzw. 31, einstellbar durch die Pulsweitenmodulation, eine Strommessung 39 am Stromsensor 24, sei es ein Kompensationswandler oder ein Shunt.

Das Auslösesignal für die Strommessung am Stromsensor 24 zu den Meßzeitpunkten 38 bei T/2 bzw. 39 bei 3T/2 wird bevorzugt vom selben Mikrocontroller erzeugt, der auch das Pulsweitenmodulations-Signal für die Transistoransteuerung bzw. die Ansteuerung der Transistorbasis 26 im mehrsträngigen Umrichter 14 liefert. Damit ist sichergestellt, daß den Mindestmeßzeiten hinsichtlich des Ein- und Ausschaltens für die Stromsensoren Rechnung getragen werden kann, da die sich einstellenden Pulspausen 30 bzw. 31 diese Mindestzeiten nicht unterschreiten dürfen.

Mittels des vorgeschlagenen Verfahrens läßt sich aus der Strommessung an nur einem Stromsensor 24, sei es ein Shunt oder ein Kompensationswandler, auf den Wert zweier versetzt geschalteter Leiterströme 3, 4 an umgewickelten Maschinen, beispielsweise Klauenpolgeneratoren, mit zwei Ständerwicklungen 12 bzw. 13 pro Strang schließen.

Bezugszeichenliste

| 1 | Taktzeit (T) |
|---|---|
| 2 | Einschaltdauer ($T_{ein}$) |
| 3 | Strom erster Leiter ($I_1$) |
| 4 | Strom zweiter Leiter ($I_2$) |
| 5 | erstes Verhältnis $T_{ein}/T$ |
| 6 | zweites Verhältnis $T_{ein}/T$ |
| 7 | Summe Ströme |
| | |
| 10 | elektrische Drehfeldmaschine |
| 11 | Wicklungspaket |
| 12 | erste Ständerwicklung |
| 13 | zweite Ständerwicklung |
| 14 | mehrsträngiger Umrichter |
| 15 | erster Umrichterstrang |
| 16 | zweiter Umrichterstrang |
| 17 | Transistor |
| 18 | Leiter erste Ständerwicklung |
| 19 | Leiter zweite Ständerwicklung |
| 20 | hoher Spannungsbereich |
| 21 | Niederspannungsseite |
| 22 | Leiter |
| 23 | Masseverbindung |
| 24 | Stromsensor |
| 25 | Sperrdiode |
| 26 | Transistorbasis |
| | |
| 30 | Pulspause $I_1$ |
| 31 | Pulspause $I_2$ |
| 32 | überlagerte Darstellung |
| 33 | halbe Taktzeit |
| 34 | Ampèremeter $I_1$ |
| 35 | Ampèremeter $I_2$ |
| 36 | Taktung T/2 |
| 37 | Taktung 3T/2 |
| 38 | Meßzeitpunkt T/2 |
| 39 | Meßzeitpunkt 3T/2 |

**Patentansprüche**

1. Verfahren zur Erfassung von Leiterströmen (3, 4) in versetzt getakteten Halbbrücken (12, 13) an einer Drehfeldmaschine (10), die an einem mehrsträngigen Umrichter (14) betrieben wird mit mindestens einem ersten Umrichterstrang (15) und einem zweiten Umrichterstrang (16), **dadurch gekennzeichnet, daß** Erfassungszeitpunkte (38, 39) der Leiterströme (3,4) derart liegen, daß in Pulspausen (30 bzw. 31) eines der Leiterströme (3, 4) die Erfassung des jeweils anderen Leiterstromes (3, 4) erfolgt.

2. Verfahren gemäß Anspruch 1, **dadurch gekennzeichnet, daß** die Leiterströme (3, 4) mit einer Abtastfrequenz gemäß

$$f = 2 \cdot f_{pwm}/n \text{ mit } n \in \{1,3,5,7,9....\}$$

abgetastet werden.

3. Verfahren gemäß Anspruch 1, **dadurch gekennzeichnet, daß** die Taktzeit T (1) der Leiterströme (3, 4) und die Pulspausen (30, 31) der Leiterströme (3, 4) sowie die Meßzeitpunkte (38, 39) über eine Auswerteelektronik synchronisiert werden.

4. Verfahren gemäß Anspruch 1, **dadurch gekennzeichnet, daß** die Leiterströme (3, 4) abwechselnd an einem Stromsensor (24) erfaßt werden.

5. Verfahren gemäß Anspruch 4, **dadurch gekennzeichnet, daß** die Leiterströme (3, 4) abwechselnd an einem Kompensationswandler erfaßt werden.

6. Verfahren gemäß Anspruch 4, **dadurch gekennzeichnet, daß** die Leiterströme (3, 4) abwechselnd an einem Shunt erfaßt werden.

7. Verfahren gemäß Anspruch 4, **dadurch gekennzeichnet, daß** der Stromsensor (24) in der Niederspannungsseite (21) des mehrsträngigen Umrichters (14) aufgenommen ist.

8. Verfahren gemäß Anspruch 4, **dadurch gekennzeichnet, daß** der Stromsensor (24) im hohen Spannungsbereich (20) des mehrsträngigen Umrichters (14) aufgenommen ist.

9. Verfahren gemäß Anspruch 1, **dadurch gekennzeichnet, daß** zu den Erfassungszeitpunkten (38, 39) der Leiterströme (3, 4) deren gemittelte Werte (7, 32) erfaßt werden.

10. Verfahren gemäß Anspruch 1, **dadurch gekennzeichnet, daß** die Pulspausen (30, 31) der Leiterströme (3, 4) abhängig vom Einschaltverhältnis

$T_{ein}/T$ (5, 6) verlaufen.

11. Verfahren gemäß Anspruch 1, **dadurch gekennzeichnet, daß** die Erfassungszeitpunkte (38, 39) zu allen Zeitpunkten gleich t = n · T/2 mit n ∈ {1, 3, 5, 7, 9...} liegen.

12. Verfahren gemäß Anspruch 3, **dadurch gekennzeichnet, daß** die Taktzeit T(1), die Pulspausen (30, 31) sowie die Meßzeitpunkte (38, 39) mittels eines Mikrocontrolers synchronisiert werden.

Fig.1.1

**50 %**

I₁ ... 3 ... 2

I₂ ... 4 ... 2 ... 2

I₁ + I₂

5 ... 7

Fig.1.2

I₁ ... 3 ... 3 ... 2 ... 2

I₂ ... 4 ... 4 ... 2 ... 2

I₁ + I₂

6 ... 7

T ... T

1 ... 1

Fig.2

Fig.3

Fig.4

Fig.5

Fig.6

30,31

32

$|_1 + |_2$

30,31

38

38
38

38

38

T/2
T/2

35 $|_2$    34 $|_1$    35 $|_2$    34 $|_1$    35 $|_2$    34 $|_1$

Fig.7

30,31

30,31

30,31

32

$|_1 + |_2$

39

3T/2

39

3T/2

39

37

37

$|_2$ 35    34 $|_1$    35 $|_2$